# EUROPÄISCHE PATENTSCHRIFT

(11) **EP 0 963 616 B1**
(45) Veröffentlichungstag und Bekanntmachung des Hinweises auf die Patenterteilung: **08.12.2004**
(21) Anmeldenummer: 98959875.0
(22) Anmeldetag: 12.11.1998
(51) Int. Cl.: H01M 8/04, G01N 27/42, G01N 27/72

(54) **VERFAHREN ZUR BESTIMMUNG DES STOFFUMSATZES BEI ELEKTROCHEMISCHEN REAKTIONEN UND ELEKTROCHEMISCHE EINHEIT**
METHOD FOR DETERMINING MATERIALS CONVERSION IN ELECTROCHEMICAL REACTIONS AND ELECTROCHEMICAL UNIT
PROCEDE PERMETTANT DE DETERMINER LA CONVERSION DE MATIERES LORS DE REACTIONS ELECTROCHIMIQUES ET UNITE ELECTROCHIMIQUE

(30) Priorität: 15.11.1997 DE 19750738
(43) Veröffentlichungstag der Anmeldung: 15.12.1999
(73) Patentinhaber: Deutsches Zentrum für Luft- und Raumfahrt e.V., 53175 Bonn (DE)
(72) Erfinder: WIESER, Christian, D-70230 Kirchheim (DE); HELMBOLD, Axel, D-70197 Stuttgart (DE)
(74) Vertreter: Beck, Jürgen, Dr. Dipl.-Phys.
(86) Internationale Anmeldenummer: PCT/EP1998/007247
(87) Internationale Veröffentlichungsnummer: WO 1999/026305

(56) Entgegenhaltungen:
- EP-A- 0 431 565
- CH-A- 522 039
- JP-A- 4 238 281
- JP-A- 5 106 076
- JP-A- 55 122 889
- US-A- 3 885 212
- US-A- 4 972 140

## Beschreibung

Die Erfindung betrifft ein Verfahren zur Bestimmung des Stoffumsatzes bei flächenhaft ablaufenden elektrochemischen Reaktionen in mindestens einem lokalen Flächenbereich zwischen einer flächenhaft ausgebildeten Gegenelektrodenanordnung und einer flächenhaft ausgebildeten Elektrodenanordnung, welche ein dem Flächenbereich entsprechend ausgebildetes Kontaktelementsegment und ein die übrigen Flächenbereiche kontaktierendes und zu dem Kontaktelementsegment elektrisch parallel angeordnetes Kontaktelement aufweist, wobei sowohl das Kontaktelement als auch das Kontaktelementsegment mit einer für das Betreiben der elektrochemischen Reaktion vorgesehenen Stromquelle oder Stromsenke verbunden werden, und wobei ein zwischen dem Kontaktelementsegment und der Stromquelle oder Stromsenke über einen Leiter fließender Strom um den Leiter herum ein Magnetfeld erzeugt.

Unter flächenhaft ablaufenden Reaktionen sind beispielsweise elektrolytische Reaktionen oder auch Reaktionen in Brennstoffzellen oder Batterien oder Akkumulatoren zu verstehen.

Aus der US-A-3,885,212 ist eine Elektrolyseanordnung bekannt, bei welcher jede Elektrolysezelle mehrere einzelne Elektroden aufweist, die über eigene Zuleitungen von einer gemeinsamen Stromquelle gespeist werden und im übrigen jede Elektrolysezelle eine gemeinsame Gegenelektrode aufweist.

Dabei ist beispielsweise in der Zuleitung zu einer der einzelnen Elektroden eine Meßeinrichtung für das Magnetfeld des von dieser erzeugten Stromes vorgesehen.

Es ist ferner aus dem Stand der Technik bekannt, zum Bestimmen des Stoffumsatzes in dem lokalen Flächenbereich das Kontaktelementsegment und das die übrigen Flächenbereiche kontaktierende Kontaktelement mit eigenen Stromquellen oder Stromsenken zu verbinden und somit die Möglichkeit zu eröffnen, den Stoffumsatz in diesem lokalen Flächenbereich unabhängig vom Stoffumsatz in den übrigen Flächenbereichen zu. erfassen und über den fließenden Strom zu definieren.

Diese Lösung ist jedoch nur dann praktizierbar, wenn bei der flächenhaft ablaufenden elektrochemischen Reaktion eine Bestimmung des Stoffumsatzes in einem, möglicherweise zwei Flächenbereichen erfolgen soll.

Darüber hinaus hat das Vorsehen mehrerer Stromquellen oder mehrerer Stromsenken Nachteile dann, wenn sowohl im Kontaktelementsegment als auch im übrigen Kontaktelement dieselben Bedingungen vorliegen sollen.

Der Erfindung liegt daher die Aufgabe zugrunde, ein Verfahren der gattungsgemäßen Art derart zu verbessern, daß der Stoffumsatz auf möglichst einfache Weise bestimmt werden kann.

Diese Aufgabe wird bei einem Verfahren der eingangs beschriebenen Art erfindungsgemäß dadurch gelöst, daß die Elektrodenanordnung zusätzlich zu dem Kontaktelement und dem Kontaktelementsegment einen Elektrodenhalter umfaßt, daß das Magnetfeld des zwischen dem mit der Stromquelle oder Stromsenke verbundenen Elektrodenhalter und dem Kontaktelementsegment fließenden Stroms gemessen wird, und daß das Magnetfeld als Maß für den Stoffumsatz in dem lokalen Flächenbereich bestimmt wird.

Der Vorteil der erfindungsgemäßen Lösung ist darin zu sehen, daß sowohl das Kontaktelementsegment als auch das übrige Kontaktelement von ein und derselben Stromquelle oder Stromsenke versorgt werden und daß somit im wesentlichen dieselben Randbedingungen für die Versorgung des Kontaktelementsegments und des übrigen Kontaktelements vorliegen. Dabei kann das Kontaktelement in üblicher Weise ausgebildet sein und sich über die übrigen Flächenbereiche erstrecken, oder das Kontaktelement kann seinerseits weitere Kontaktelementsegmente umfassen.

Darüber hinaus ist erfindungsgemäß vorgesehen, den über den zum Kontaktelement führenden Leiter fließenden Strom besonders einfach und für die elektrochemische Reaktion störungsfrei zu messen, nämlich über das sich um den Leiter herum ausbildende magnetische Feld, welches somit eine Strommessung ohne Eingriff in die Stromversorgung des Kontaktelementsegments selbst ermöglicht.

Ferner ist die erfindungsgemäße Lösung auch deshalb von Vorteil, weil bei flächenhaften elektrochemischen Reaktionen in der Regel sehr hohe Ströme auftreten und somit die Zwischenschaltung von sogenannten "Shunt-Widerständen" erhebliche Probleme bereiten würde, während die erfindungsgemäße Messung des sich um den Leiter ausbildenden Magnetfeldes sehr einfach und problemlos durchführbar ist, ohne einen zusätzlichen Eingriff in die Stromversorgung machen zu müssen.

Besonders vorteilhaft ist eine Lösung, bei welcher der Leiter in einer Richtung verläuft und das den Leiter azimutal zu dieser Richtung umgebende Magnetfeld bestimmt wird.

Das Magnetfeld kann auf unterschiedlichste Art und Weise bestimmt werden. So sieht eine vorteilhafte Lösung vor, daß das Magnetfeld mittels eines elektrischen Magnetfeldsensors bestimmt wird.

Hinsichtlich der Ausbildung eines derartigen Magnetfeldsensors sind die unterschiedlichsten Sensorlösungen denkbar. Eine besonders vorteilhafte und hinsichtlich ihrer Empfindlichkeit bevorzugte Lösung sieht vor, daß als Magnetfeldsensor ein Hallsensor verwendet wird.

Um das Magnetfeld möglichst auf engem Raum zu führen und somit auch einen möglichst großen magnetischen Fluß mittels des Magnetfeldsensors messen zu können, ist vorzugsweise vorgesehen, daß das Magnetfeld durch ein magnetfeldführendes Element geführt wird.

Das magnetfeldführende Element ist vorzugsweise so ausgebildet, daß es den Leiter zumindest teilweise azimutal umschließt.

Damit ist zumindest in dem Bereich, in dem das magnetfeldführende Element den Leiter umschließt, nicht nur eine Führung des Magnetfeldes, sondern eine über das magnetfeldführende Element hinausgehende Abschirmwirkung erzielbar.

Besonders günstig ist es, wenn das magnetfeldführende Element beidseitig des Magnetfeldsensors endet und somit nicht nur eine Konzentrierung des Magnetfeldes dahingehend bewirkt, daß dieses den Magnetfeldsensor weitestgehend durchflutet, sondern auch eine Abschirmung des Feldes.

Besonders günstig ist es dabei, wenn das magnetfeldführende Element mit einem Spalt versehen wird, in welchem der Magnetfeldsensor angeordnet ist.

Das magnetfeldführende Element wirkt dann optimal, wenn dieses aus einem weichmagnetischen Material gewählt wird. Besonders günstig ist es, wenn das magnetfeldführende Element aus einem Ferritmaterial gebildet wird.

Eine insbesondere für eine Stapelung von Elektroden- und Gegenelektrodenanordnungen vorteilhafte Lösung sieht vor, daß der Leiter innerhalb eines Elektrodenhalters angeordnet wird und somit innerhalb des Elektrodenhalters selbst eine Messung des Magnetfeldes zur Bestimmung des Stroms und somit auch des Stoffumsatzes durchgeführt wird.

Darüber hinaus betrifft die Erfindung eine elektrochemische Einheit Umfassend eine chemische Reaktionseinheit, gemäß dem unabhängigen Anspruch 9 ist.

Der Vorteil dieser Lösung ist ebenfalls darin zu sehen, daß damit eine Möglichkeit geschaffen wurde, auf einfache Art und Weise, insbesondere ohne in das System selbst einzugreifen, den lokalen Stoffumsatz in der Reaktionseinheit zu bestimmen.

Vorzugsweise ist dabei der Leiter so ausgebildet, daß er sich in einer Richtung erstreckt und daß mit dem Magnetfeldsensor das um diese Richtung azimutal umlaufende Magnetfeld bestimmbar ist.

Prinzipiell wäre es denkbar, das sich um den Leiter im freien Raum herum ausbreitende Magnetfeld zu messen. Um jedoch eine möglichst große Durchflutung des Magnetfeldsensors zu erreichen, ist vorzugsweise vorgesehen, daß das Magnetfeld ein magnetfeldführendes Element durchsetzt, so daß hierdurch die magnetische Durchflutung des Magnetfeldsensors möglichst groß gewählt werden kann.

Eine besonders günstige Lösung sieht vor, daß das magnetfeldführende Element den Leiter zumindest teilweise azimutal umgibt, so daß dadurch nicht nur eine Führung des Magnetfeldes sondern auch eine Abschirmung des Magnetfeldes gegen eine weiträumige Streuung möglich ist.

Vorzugsweise ist dabei das magnetfeldführende Element so ausgebildet, daß es beidseitig des Magnetfeldsensors endet, um somit einen möglichst großen Teil des Magnetfeldes zur Durchflutung des Magnetfeldsensors heranzuziehen.

Eine besonders günstige Lösung sieht vor, daß das magnetfeldführende Element einen Spalt aufweist, in welchem der Magnetfeldsensor angeordnet ist.

Eine besonders günstige Ausführungsform des magnetfeldführenden Elements sieht vor, daß dieses ungefähr C-förmig ausgebildet ist, wobei die C-Form eine eckige Grundform oder eine gerundete Grundform definiert. Im günstigsten Fall die C-förmige Ausbildung des magnetfeldführenden Elements dazu führt, daß dieses als Ring oder Joch mit einem radialen Ringspalt oder Jochspalt ausgebildet ist.

Hinsichtlich des Materials für das magnetfeldführende Element wurden bislang keine weiteren Angaben gemacht. Eine besonders günstige Lösung sieht vor, daß das magnetfeldführende Element aus einem weichmagnetischen Material hergestellt ist. Ein derartiges weichmagnetisches Material kann beispielsweise ein Material sein, wie es für Transformatorenbleche Verwendung findet.

Noch vorteilhafter ist es, wenn das magnetfeldführende Element aus einem Ferrit ausgebildet ist, da dieses eine noch stärker führende Funktion auf das Magnetfeld ausübt.

Um nun bei der erfindungsgemäßen Lösung einen Einbau in ein stapelähnliches oder ein gestapeltes System zu ermöglichen, ist vorzugsweise vorgesehen, daß ein Elektrodenhalter der Elektrodenanordnung so ausgebildet ist, daß in diesem der Leiter angeordnet ist, welcher zu dem Kontaktelementsegment führt.

Vorzugsweise ist dabei der Leiter auf einer Elektrodenhalterplatte oder dem Kontaktelementsegment angeordnet und steht von dieser über.

Um bei der Anordnung des Leiters in dem Elektrodenhalter in geeigneter Weise eine Messung des Magnetfeldes vornehmen zu können, ist vorzugsweise vorgesehen, daß im Elektrodenhalter der Leiter von einem Raum umgeben ist.

Vorzugsweise ist dabei bei Vorsehen eines magnetfeldführenden Elements dieses in dem Raum angeordnet. Bei dieser Lösung besteht die Möglichkeit, das Magnetfeld innerhalb des Elektrodenhalters zu messen, und zwar das Magnetfeld des Stroms, der von der Elektrodenhalterplatte zum Kontaktelementsegment führt.

Vorzugsweise ist dabei der Leiter zapfenähnlich ausgebildet. Ein Ausführungsbeispiel sieht vor, daß der zapfenähnliche Leiter einstückig an eine Elektrodenhalterplatte oder das Kontaktelementsystem angeformt ist.

Um in geeigneter Weise eine bestehende Verbindung zwischen dem Kontaktelementsegment und dem als Leiter dienenden Zapfen zu schaffen, ist vorzugsweise vorgesehen, daß sich der zapfenähnliche Leiter auf einer Rückseite des Kontaktelementsegments abstützt und somit elektrisch leitend mit diesem verbunden ist.

Hinsichtlich der Ausfüllung des um den Leiter herum existierenden Raums in dem Elektrodenhalter wurden bislang keine näheren Angaben gemacht. Beispielsweise könnte dieser auch als Hohlraum bestehen bleiben. Eine besonders günstige Lösung sieht jedoch vor, daß dieser - insoweit als er nicht durch den Magnetfeldsensor oder das magnetfeldführende Element ausgefüllt ist - durch ein das Magnetfeld nicht beeinflussendes und elektrisch nichtleitendes Material ausgefüllt ist, so daß damit keinerlei unerwünschte Hohlräume in dem Elektrodenhalter entstehen.

Vorzugsweise ist dieses Material gleichzeitig auch als elektrisch isolierendes Material zwischen dem Kontaktelementsegment und dem übrigen Kontaktelement vorgesehen.

Eine besonders günstige Lösung sieht vor, daß dieses Material Kunststoffmaterial, vorzugsweise Silikon, ist.

Weitere Merkmale und Vorteile der Erfindung sind Gegenstand der nachfolgenden Beschreibung sowie der zeichnerischen Darstellung einiger Ausführungsbeispiele. In der Zeichnung zeigen:
- Fig. 1: einen Längsschnitt durch ein erstes Ausführungsbeispiel einer eine elektrochemische Einheit darstellenden Brennstoffzelle;

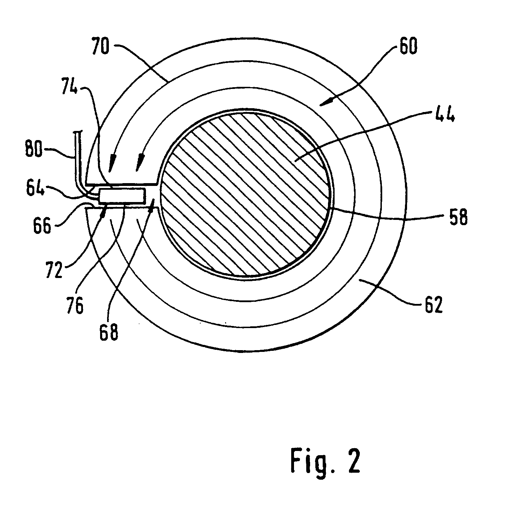

- Fig. 2: einen Schnitt längs Linie 2-2 in Fig. 1;
- Fig. 3: eine Draufsicht auf die Elektrodenanordnung des ersten Ausführungsbeispiels, wobei rechts oben im Bereich eines ersten nicht dargestellten Kontaktelementsegments nur der Leiter und die Elektrodenhalterplatte dargestellt sind, im Bereich des darunter liegenden Kontaktelementsegments der Leiter mit dem diesen umgebenden magnetfeldführenden Element und Magnetfeldsensor und im Bereich des weiter darunter liegenden Kontaktelementsegments noch der Leiter und das magnetfeldführende Element angedeutet sind, während im übrigen lediglich die Kontaktelementsegmente sichtbar sind; und
- Fig. 4: eine Draufsicht auf ein zweites Ausführungsbeispiel einer erfindungsgemäßen Elektrodenanordnung, welche lediglich zwei Kontaktelementsegmente aufweist, die gegenüber dem übrigen Kontaktelement elektrisch parallel angeordnet sind.

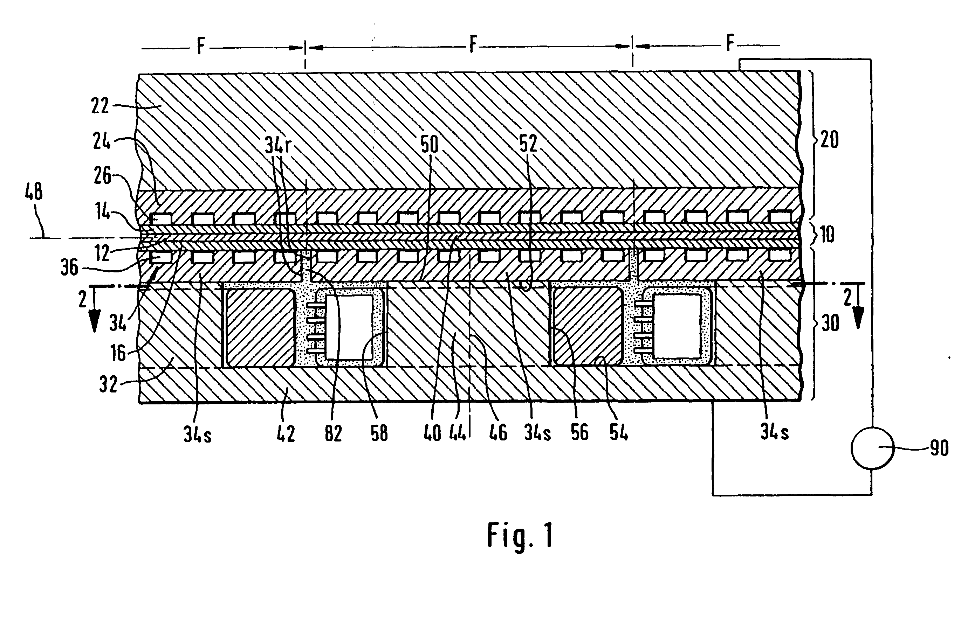

Eine Brennstoffzelle als Ausführungsbeispiel für eine erfindungsgemäße elektrochemische Einheit, ausschnittsweise dargestellt in Fig. 1, umfaßt eine als Ganzes mit 10 bezeichnete Reaktionseinheit, welche im Fall der Brennstoffzelle eine Membran 12 aufweist, welche beiderseits mit Schichten 14 und 16 versehen ist, die ein Katalysatormaterial und leitfähiges, sogenanntes Elektrodenmaterial umfassen, wobei diese Schichten 14 und 16 aus Elektrodenmaterial und Katalysatormaterial gasdurchlässig sind.

Die Reaktionseinheit 10 wird einerseits kontaktiert durch eine Gegenelektrodenanordnung 20, welche einen Gegenelektrodenhalter 22 und als Kontaktelement 24 ein Gasverteilerelement aufweist, wobei das Gasverteilerelement die Schicht 14 kontaktiert und gleichzeitig der Schicht 14 zugewandte Gaskanäle 26 aufweist, über welche der gasdurchlässigen Schicht 14 das jeweilige zur Reaktion erforderliche Gas zuführbar ist. Diese Gaskanäle 26 sind mit einer externen Gasversorgung, in Fig. 1 nicht dargestellt, verbunden.

Außerdem ist die Reaktionseinheit 10 mit einer Elektrodenanordnung 30 kontaktiert, welche einen Elektrodenhalter 32 aufweist und an der Schicht 16 mit einem Kontaktelement 34 anliegt, das ebenfalls als Gasverteilerelement ausgebildet ist und der Schicht 16 zugewandte Gaskanäle 36 aufweist, über welche eine Gaszufuhr zu der gasdurchlässigen Schicht 16 möglich ist. Die Gaskanäle 36 sind ebenfalls wieder mit einer externen Gasversorgung verbunden.

Allerdings ist das Kontaktelement 34 aus verschiedenen Kontaktelementsegmenten 34s ausgebildet, die jeweils ungefähr eine entsprechende Ausdehnung aufweisenden definierten Flächenbereichen 40 der Reaktionseinheit 10 zugeordnet sind, wobei jeder der Flächenbereiche 40, beispielsweise in der in Fig. 1 dargestellten Schnittebene, die Ausdehnung F aufweist.

Zur Kontaktierung der Kontaktelementsegmente 34s weist der Elektrodenhalter 32 eine sogenannte Elektrodenhalterplatte 42 auf, von welcher sich in Richtung der Kontaktelementsegmente 34s erstreckende, im Querschnitt zylindrisch ausgebildete und einen elektrischen Leiter darstellende Vorsprünge 44 erheben, deren Zylinderachse 46 im wesentlichen quer zu einer Ebene 48 verläuft, in welcher sich die Reaktionseinheit 10 erstreckt und zu welcher parallel sich auch die Kontaktelementsegmente 34s erstrecken, wobei die Vorsprünge 44 mit ihrer den Kontaktelementsegmenten 34s zugewandten Stirnfläche 50 an einer der Reaktionseinheit 10 abgewandten Rückseite 52 der Kontaktelementsegmente 34s unter Ausbildung einer elektrisch leitfähigen Verbindung anliegen.

Damit stellen die Vorsprünge 44 einen elektrischen Leiter zur Führung eines Stroms zwischen den Kontaktelementsegmenten 34s und der Elektrodenhalterplatte 42 dar.

Dadurch, daß die im Querschnitt zylinderförmigen Vorsprünge 44 über einer dem Kontaktelement 34 zugewandten Seite der Elektrodenhalterplatte 42 in Richtung der Kontaktelementsegmente 34 vorspringen, bildet sich um die zylinderförmigen Vorsprünge 44 herum und zwischen der Rückseite 52 der Kontaktelementsegmente 34 sowie der Seite 54 der Elektrodenhalterplatte 42 ein Raum 56, welcher den Vorsprung 44 im Anschluß an seine Zylindermantelfläche 58 umgibt.

In dem Raum 56 ist nun ein magnetfeldführendes Element 60 vorgesehen, welches beispielsweise als Ringkörper 62 ausgebildet ist, wobei Enden 64 und 66 des Ringkörpers nicht ineinander übergehen, so daß der Ringkörper 62 geschlossen ist, sondern im Abstand voneinander angeordnet sind und zwischen sich einen Spalt 68 bilden.

Das magnetfeldführende Element 60 ist vorzugsweise aus jeder Art weichmagnetischen Materials ausgebildet, insbesondere aus Ferrit, und konzentriert ein Magnetfeld 70, welches sich um die Zylinderachse 46 umlaufend um den als elektrischen Leiter ausgebildeten zylindrischen Vorsprung 44 herum ausbildet, wenn dieser in Richtung der Zylinderachse 46 von einem Strom durchsetzt ist.

Zur Messung des Magnetfelds 70 ist in dem Spalt 68 ein als Ganzes mit 72 bezeichneter Magnetfeldsensor, vorzugsweise ein Hallsensor, vorgesehen, dessen Flachseiten 74, 76 den Enden 64, 66 zugewandt sind, so daß das Magnetfeld 70 den Hallsensor 72 quer zu dessen Flachseiten 74, 76 verlaufend diesen durchflutet.

Bevorzugterweise weist der im Querschnitt zylinderförmige Vorsprung 44 als Zylindermantelfläche 58 eine zur Zylinderachse 46 kreiszylindrisch geformte Mantelfläche 58 auf, es ist jedoch aber auch denkbar, alle möglichen Querschnittsformen des zylindrischen Vorsprungs 44 zu wählen.

Zu dem Hallsensor 72 führende Anschlußleitungen 80 sind über die um die jeweils benachbarten Vorsprünge 44 vorliegenden Räume 56 aus dem Elektrodenhalter 32 nach außen geführt.

Zur Abdichtung zwischen den einzelnen Kontaktelementsegmenten 34s ist zwischen den einander zugewandten Rändern 34r derselben eine Dichtungsmasse 82, vorzugsweise Silikon, vorgesehen, welche die Kontaktelementsegmente 34s gegeneinander abdichtet. Die Dichtungsmasse 82 dient ferner auch noch zur Einbettung der Magnetfeldführungselemente 60 und der Hallsensoren 72 sowie der Zuleitungen 80.

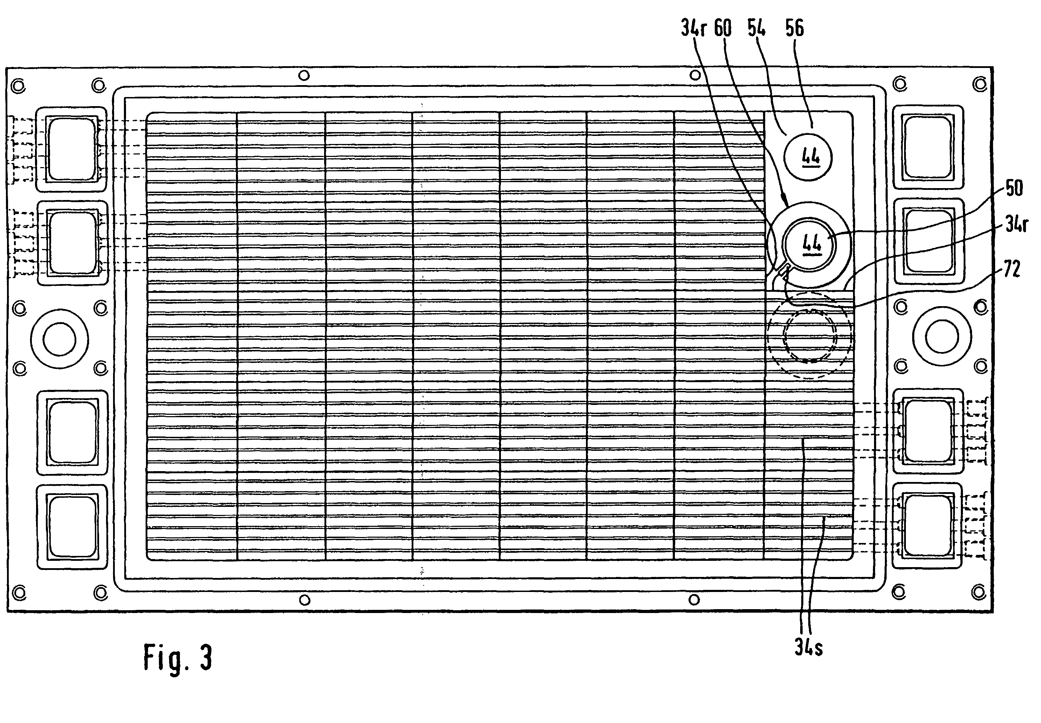

Ist, wie beispielsweise in Fig. 3 dargestellt, die gesamte Elektrodenanordnung 30 aus einer Vielzahl von Kontaktelementsegmenten 34s gebildet, so ist der Elektrodenhalter 32 mit einer Vielzahl sich über dessen der Reaktionseinheit zugewandten Seite 54 erhebenden zylindrischen Vorsprüngen 44 versehen, so daß um die zylindrischen Vorsprünge 44 herum der Raum 56 zur Verfügung steht, in welchem die magnetfeldführenden Elemente 60 mit den Magnetfeldsensoren 72 angeordnet werden können. Dieser gesamte Raum 56 wird nach Einsetzen der magnetfeldführenden Einheiten 60 und den Magnetfeldsensoren 72 noch zusätzlich mit der Dichtungsmasse 82 aufgefüllt. Ferner werden auf die als Leiter wirkenden zylindrischen Vorsprünge 44 die einzelnen Kontaktelementsegmente 34s aufgelegt, so daß diese mit ihrer Rückseite 52 mit der jeweiligen Stirnfläche 50 der Vorsprünge 44 in elektrischem Kontakt stehen.

Durch Messung der sich jeweils um die zylindrischen Vorsprünge 44 ausbildenden Magnetfelder 70 mittels der Magnetfeldsensoren 72 besteht die Möglichkeit, den zu jedem einzelnen Kontaktelementsegment 34s fließenden Strom zu messen und aus diesem Strom dann auf den Stoffumsatz in der dem jeweiligen Kontaktelementsegment 34s entsprechenden Flächenbereich 40 zu schließen.

Im Fall einer Brennstoffzelle sind beispielsweise der Gegenelektrodenhalter 22 und der Elektrodenhalter 32 mit einer Stromsenke 90 verbunden, zu welcher der durch die chemische Reaktion in der Reaktionseinheit 10 entstehende Strom fließt. Die Einheit aus Reaktionseinheit 10 sowie Gegenelektrodenanordnung 20 und Elektrodenanordnung 30 kann jedoch vervielfacht in Form eines Stapels aufgebaut werden, so daß lediglich dann die Stromsenke über die aufeinander gestapelten elektrochemischen Einheiten verbunden ist.

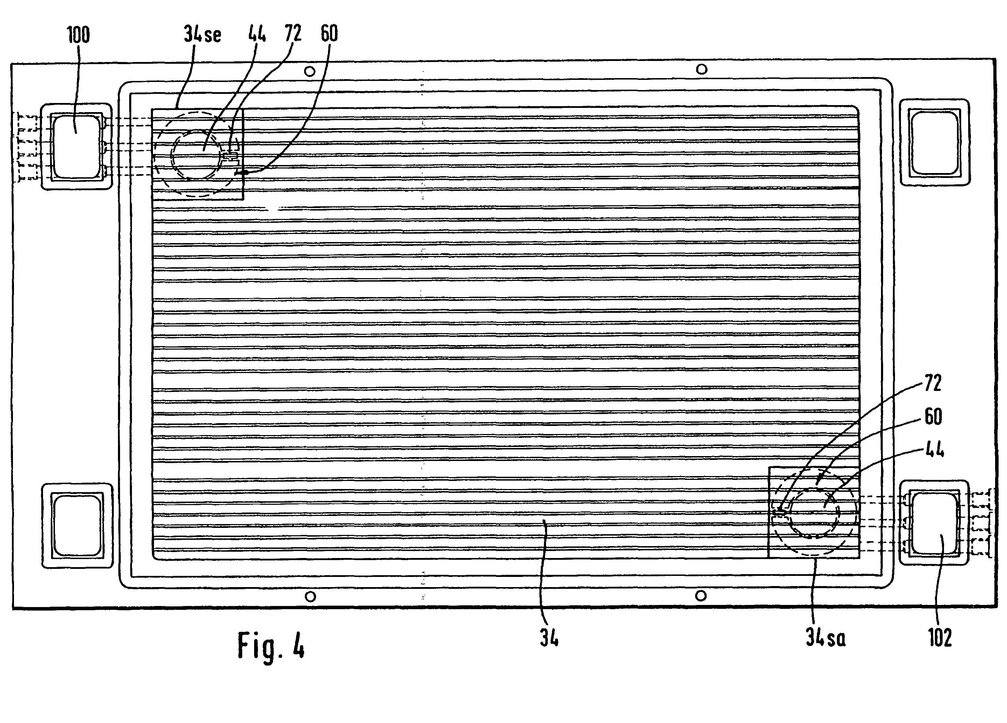

Bei einem anderen Einsatzfall der erfindungsgemäßen Lösung bei einer Brennstoffzelle, dargestellt in Fig. 4, ist lediglich ein nahe einem Gaseinlaß 100 liegendes Kontaktelementsegment 34se und ein nahe einem Gasauslaß 102 naheliegendes Kontaktelement 34sa von dem übrigen Kontaktelement 34 elektrisch getrennt ausgebildet und über einen Leiter 44 des Elektrodenhalters 32 elektrisch mit der Elektrodenhalterplatte 44 verbunden, wobei ebenfalls wiederum mit dem magnetfeldführenden Element 60 und einem zugeordneten Magnetfeldsensor 72 eine Strommessung erfolgt, welche Rückschlüsse über den Stoffumsatz in dem dem jeweiligen Kontaktelementsegment 34se, 34sa gegenüberliegenden Flächenbereich 40 zuläßt.

Da eine Analyse des Stoffumsatzes in einem Flächenbereich der Reaktionseinheit 10 in der Nähe des Gaseinlasses 100 und des Stoffumsatzes in einem Flächenbereich 40 in der Nähe des Gasauslasses 102 weitreichende Aufschlüsse über die Wirkungsweise der Reaktionseinheit 10 dieser einen Einheit zuläßt, lassen sich bereits mit zwei Messungen des Stoffumsatzes Erkenntnisse über die Funktionsfähigkeit der gesamten Reaktionseinheit 10 einer einzigen elektrochemischen Einheit gewinnen.

## Patentansprüche

1. Verfahren zur Bestimmung des Stoffumsatzes bei flächenhaft ablaufenden elektrochemischen Reaktionen in mindestens einem lokalen Flächenbereich zwischen einer flächenhaft ausgebildeten Gegenelektrodenanordnung (20) und einer flächenhaft ausgebildeten Elektrodenanordnung (30), welche ein dem Flächenbereich (40) entsprechend ausgebildetes Kontaktelementsegment (34s) und ein die übrigen Flächenbereiche kontaktierendes und zu dem Kontaktelementsegment (34s) elektrisch parallel angeordnetes Kontaktelement (34) aufweist, wobei sowohl das Kontaktelement (34) als auch das Kontaktelementsegment (34s) mit einer für das Betreiben der elektrochemischen Reaktion vorgesehenen Stromquelle oder Stromsenke (90) verbunden werden, und wobei ein zwischen dem Kontaktelementsegment (34s) und der Stromquelle oder Stromsenke (90) über einen Leiter (44) fließender Strom um den Leiter (44) herum ein Magnetfeld (70) erzeugt,
**dadurch gekennzeichnet , daß** die Elektrodenanordnung (30) zusätzlich zu dem Kontaktelement (34) und dem Kontaktelementsegment (34s) einen Elektrodenhalter (32) umfaßt, daß das Magnetfeld (70) des zwischen dem mit der Stromquelle oder Stromsenke (90) verbundenen Elektrodenhalter (32) und dem Kontaktelementsegment (34s) fließenden Stroms gemessen wird, und daß das Magnetfeld (70) als Maß für den Stoffumsatz in dem lokalen Flächenbereich (40) bestimmt wird.

2. Verfahren nach Anspruch 1, **dadurch gekennzeichnet, daß** der Leiter (44) in einer Richtung (46) verläuft und daß das den Leiter (44) azimutal zu dieser Richtung (46) umgebende Magnetfeld (70) bestimmt wird.

3. Verfahren nach Anspruch 1 oder 2, **dadurch gekennzeichnet, daß** das Magnetfeld (70) mittels eines elektrischen Magnetfeldsensors (72) bestimmt wird.

4. Verfahren nach einem der voranstehenden Ansprüche, **dadurch gekennzeichnet, daß** das Magnetfeld (70) durch ein magnetfeldführendes Element (60) geführt wird.

5. Verfahren nach Anspruch 4, **dadurch gekennzeichnet, daß** das magnetfeldführende Element (60) so ausgebildet wird, daß es den Leiter (44) zumindest teilweise azimutal umschließt.

6. Verfahren nach Anspruch 4 oder 5, **dadurch gekennzeichnet, daß** das magnetfeldführende Element (60) beidseitig des Magnetfeldsensors (72) endet.

7. Verfahren nach einem der Ansprüche 4 bis 6, **dadurch gekennzeichnet, daß** das magnetfeldführende Element aus einem weichmagnetischen Material ausgebildet wird.

8. Verfahren nach einem der voranstehenden Ansprüche, **dadurch gekennzeichnet, daß** das Magnetfeld (70) innerhalb eines Elektrodenhalters (32) gemessen wird.

9. Elektrochemische Einheit umfassend eine Reaktionseinheit, in welcher eine flächenhafte chemische Reaktion abläuft, und eine einerseits an der Reaktionseinheit anliegende flächenhaft ausgebildete Gegenelektrodenanordnung (20) sowie eine andererseits an der Reaktionseinheit anliegende flächenhaft ausgebildete Elektrodenanordnung (30), welche ein einem lokalen Flächenbereich (40) der Reaktionseinheit entsprechend ausgebildetes und diesen kontaktierendes Kontektelementsegment (34s) und ein die übrigen Flächenbereiche der Reaktionseinheit kontaktierendes und zu dem Kontaktelementsegment (34s) elektrisch parallel angeordnetes Kontaktelement (34) aufweist, und einen Magnetfeldsensor (72) wobei sowohl das Kontaktelement (34) als auch das Kontaktelementsegment (34s) mit einer für das Betrelben der elektrochemischen Reaktion vorgesehenen Stromquelle oder Stromsenke (90) verbunden sind, und das Kontaktelementsegment (34s) über einen Leiter (44) mit der Stromquelle oder Stromsenke (90) verbunden ist, wodurch ein über den Leiter (44) zwischen dem Kontaktelementsegment (34s) und der Stromquelle oder Stromsenke (90) fließender Strom um den Leiter (44) herum ein Magnetfeld (70) erzeugt, das mittels des Magnetfeldsensors (72) erfassbar ist, **dadurch gekennzeichnet, daß** die Elektrodenanordnung (30) zusätzlich zu dem Kontaktelement (34) und dem Kontaktelementsegment (34s) einen Elektrodenhalter (32) umfaßt so daß mittels des Magnetfeldsensors (72) das von dem zwischen dem Elektrodenhalter (32) und dem Kontaktelementsegment (34s) fließenden Strom erzeugte Magnetfeld (70) als Maß für den Stoffumsatz in dem lokalen Flächenbereich bestimmbar ist.

10. Elektrochemische Einheit nach Anspruch 9, **dadurch gekennzeichnet, daß** der Leiter (44) sich in einer Richtung (46) erstreckt und daß mit dem Magnetfeldsensor (72) das um diese Richtung (46) azimutal umlaufende Magnetfeld (70) bestimmbar ist.

11. Elektrochemische Einheit nach Anspruch 9 oder 10, **dadurch gekennzeichnet, daß** das Magnetfeld (70) ein magnetfeldführendes Element (60) durchsetzt.

12. Elektrochemische Einheit nach Anspruch 11, **dadurch gekennzeichnet, daß** das magnetfeldführende Element (60) den Leiter (44) zumindest teilweise azimutal umgibt.

13. Elektrochemische Einheit nach Anspruch 11 oder 12, **dadurch gekennzeichnet, daß** das magnetfeldführende Element (60) so ausgebildet ist, daß es beidseitig des Magnetfeldsensors (72) endet.

14. Elektrochemische Einheit nach Anspruch 13, **dadurch gekennzeichnet, daß** das magnetfeldführende Element (60) einen Spalt (68) aufweist, in welchem der Magnetfeldsensor (72) angeordnet ist.

15. Elektrochemische Einheit nach einem der Ansprüche 11 bis 14, **dadurch gekennzeichnet, daß** das magnetfeldführende Element (60) aus einem weichmagnetischen Material hergestellt ist.

16. Elektrochemische Einheit nach einem der Ansprüche 11 bis 14, **dadurch gekennzeichnet, daß** das magnetfeldführende Element (60) aus einem Ferrit ausgebildet ist.

17. Elektrochemische Einheit nach einem der Ansprüche 9 bis 16, **dadurch gekennzeichnet, daß** ein Elektrodenhalter .(32) der Elektrodenanordnung (30) so ausgebildet ist, daß in diesem der Leiter (44) angeordnet ist, welcher zu dem Kontaktelementsegment (34) führt.

18. Elektrochemische Einheit nach Anspruch 17, **dadurch gekennzeichnet, daß** der Leiter (44) auf einer Elektrodenhalterplatte (42) oder dem Kontaktelementsegment angeordnet ist und über diese übersteht.

19. Elektrochemische Einheit nach Anspruch 17 oder 18, **dadurch gekennzeichnet, daß** im Elektrodenhalter (32) der Leiter (44) von einem Raum (56) umgeben ist.

20. Elektrochemische Einheit nach Anspruch 19, **dadurch gekennzeichnet, daß** das magnetfeldführende Element (60) in dem Raum (56) angeordnet ist.

21. Elektrochemische Einheit nach einem der Ansprüche 9 bis 20, **dadurch gekennzeichnet, daß** der Leiter (44) zapfenähnlich ausgebildet ist.

22. Elektrochemische Einheit nach Anspruch 21, **dadurch gekennzeichnet, daß** der zapfenähnliche Leiter (44) einstückig an die Elektrodenhalterplatte (42) oder das Kontaktelement angeformt ist.

23. Elektrochemische Einheit nach Anspruch 21 oder 22, **dadurch gekennzeichnet, daß** sich der zapfenähnliche Leiter (44) auf einer Rückseite (52) des Kontaktelementsegments (34s) abstützt.

24. Elektrochemische Einheit nach einem der Ansprüche 19 bis 23, **dadurch gekennzeichnet, daß** der Ringraum (56) durch ein das Magnetfeld (70) nicht beeinflussendes und elektrisch nicht leitendes Material ausgefüllt ist.

## Claims

1. Method for determining the substance conversion during areal electrochemical reactions in at least one local surface area between a counterelectrode arrangement (20) of an areal design and an electrode arrangement (30) of an areal design, said electrode arrangement having a contact element segment (34s) designed in accordance with the surface area (40) and a contact element (34) contacting the remaining surface areas and being arranged electrically parallel to the contact element segment (34s), wherein not only the contact element (34) but also the contact element segment (34s) are connected to a current source or current sink (90) provided for carrying out the electrochemical reaction, and wherein a current flowing between the contact element segment (34s) and the current source or current sink (90) via a conductor (44) generates a magnetic field (70) around the conductor (44), **characterized in that** the electrode arrangement (30) comprises an electrode holder (32) in addition to the contact element (34) and the contact element segment (34s), that the magnetic field (70) of the current flowing between the electrode holder (32) connected to the current source or current sink (90) and the contact element segment (34s) is measured, and that the magnetic field (70) is determined as a measure for the substance conversion in the local surface area (40).

2. Method as defined in claim 1, **characterized in that** the conductor (44) extends in one direction (46) and that the magnetic field surrounding the conductor (44) azimuthally to this direction (46) is determined.

3. Method as defined in claim 1 or 2, **characterized in that** the magnetic field (70) is determined by means of an electric magnetic field sensor (72).

4. Method as defined in any one of the preceding claims, **characterized in that** the magnetic field (70) is guided through a magnetic field-guiding element (60).

5. Method as defined in claim 4, **characterized in that** the element (60) guiding the magnetic field is designed such that it at least partially surrounds the conductor (44) azimuthally.

6. Method as defined in claim 4 or 5, **characterized in that** the element (60) guiding the magnetic field ends on both sides of the magnetic field sensor (72).

7. Method as defined in any one of claims 4 to 6, **characterized in that** the element guiding the magnetic field is formed from a soft magnetic material.

8. Method as defined in any one of the preceding claims, **characterized in that** the magnetic field (70) is measured within an electrode holder (32).

9. Electrochemical unit comprising a reaction unit, an areal chemical reaction occurring in said reaction unit, and a counterelectrode arrangement (20) of an areal design abutting on the reaction unit on the one side as well as an electrode arrangement (30) of an areal design abutting on the reaction unit on the other side, said electrode arrangement having a contact element segment (34s) designed in accordance with a local surface area (40) of the reaction unit and contacting it and a contact element (34) contacting the remaining surface areas of the reaction unit and being arranged electrically parallel to the contact element segment (34s), and a magnetic field sensor (72), wherein not only the contact element (34) but also the contact element segment (34s) are connected to a current source or current sink (90) provided for carrying out the electrochemical reaction and the contact element segment (34s) is connected to the current source or current sink (90) via a conductor (44), whereby a current flowing via the conductor (44) between the contact element segment (34s) and the current source or current sink (90) generates a magnetic field (70) around the conductor (44), said magnetic field being detectable by means of the magnetic field sensor (72), **characterized in that** the electrode arrangement (30) comprises an electrode holder (32) in addition to the contact element (34) and the contact element segment (34s) so that the magnetic field (70) generated by the current flowing between the electrode holder (32) and the contact element segment (34s) is determinable as a measure for the substance conversion in the local surface area by means of the magnetic field sensor (72).

10. Electrochemical unit as defined in claim 9, **characterized in that** the conductor (44) extends in one direction (46) and that the magnetic field (70) extending around this direction (46) azimuthally is determinable with the magnetic field sensor (72).

11. Electrochemical unit as defined in claim 9 or 10, **characterized in that** the magnetic field (70) passes through an element (60) guiding the magnetic field.

12. Electrochemical unit as defined in claim 11, **characterized in that** the element (60) guiding the magnetic field at least partially surrounds the conductor (44) azimuthally.

13. Electrochemical unit as defined in claim 11 or 12, **characterized in that** the element (60) guiding the magnetic field is designed such that it ends on both sides of the magnetic field sensor (72).

14. Electrochemical unit as defined in claim 13, **characterized in that** the element (60) guiding the magnetic field has a gap (68), the magnetic field sensor (72) being arranged in said gap.

15. Electrochemical unit as defined in any one of claims 11 to 14, **characterized in that** the element (60) guiding the magnetic field is produced from a soft magnetic material.

16. Electrochemical unit as defined in any one of claims 11 to 14, **characterized in that** the element (60) guiding the magnetic field is formed from a ferrite.

17. Electrochemical unit as defined in any one of claims 9 to 16, **characterized in that** an electrode holder (32) of the electrode arrangement (30) is designed such that the conductor (44) leading to the contact element segment (34) is arranged in it.

18. Electrochemical unit as defined in claim 17, **characterized in that** the conductor (44) is arranged on an electrode holder plate (42) or the contact element segment and projects beyond it.

19. Electrochemical unit as defined in claim 17 or 18, **characterized in that** the conductor (44) is surrounded in the electrode holder (32) by a space (56).

20. Electrochemical unit as defined in claim 19, **characterized in that** the element (60) guiding the magnetic field is arranged in the space (56).

21. Electrochemical unit as defined in any one of claims 9 to 20, **characterized in that** the conductor (44) is designed like a pin.

22. Electrochemical unit as defined in claim 21, **characterized in that** the pin-like conductor (44) is integrally formed on the electrode holder plate (42) or the contact element.

23. Electrochemical unit as defined in claim 21 or 22, **characterized in that** the pin-like conductor (44) is supported on a rear side (52) of the contact element segment (34s).

24. Electrochemical unit as defined in any one of claims 19 to 23, **characterized in that** the annular space (56) is filled by an electrically non-conductive material not influencing the magnetic field (70).

## Revendications

1. Procédé permettant de déterminer la conversion de matières lors de réactions électrochimiques se déroutant superficiellement dans au moins une zone locale de surface entre un ensemble de contre-électrodes configuré superficiellement (20) et un ensemble d'électrodes configuré superficiellement (30), lequel comprend un segment d'élément de contact (34s) configuré en conformité avec la zone de surface (40) et un élément de contact (34) assurant le contact avec les autres zones de surface et disposé électriquement en parallèle avec le segment de d'élément de contact (34s), dans lequel aussi bien l'élément de contact (34) que le segment d'élément de contact (34s) sont reliés avec une source de courant ou avec un élément abaisseur de courant (90) prévu pour l'exploitation de la réaction électrochimique et dans lequel un courant circulant à travers un conducteur (44) entre le segment d'élément de contact (34s) et la source de courant ou l'élément abaisseur de courant (90) génère un champ magnétique (70) autour du conducteur (44), **caractérisé en ce qu'**en plus de l'élément de contact (34) et du segment d'élément de contact (34s) l'ensemble d'électrodes (30) comprend un support d'électrodes (32), **en ce que** le champ magnétique (70) généré par le courant circulant entre le support d'électrodes (32) relié avec la source de courant ou avec l'élément abaisseur de courant (90) et le segment d'élément de contact (34s) est mesuré et **en ce que** le champ magnétique (70) est déterminé comme quantité pour la conversion de matière dans la zone locale de surface (40).

2. Procédé selon la revendication 1, **caractérisé en ce que** le conducteur (44) s'étend dans une direction (46) et **en ce qu'**a lieu une détermination du champ magnétique (70) entourant le conducteur (44) dans le sens azimutal par rapport à cette direction (46).

3. Procédé selon la revendication 1 ou 2, **caractérisé en ce que** le champ magnétique (70) est déterminé au moyen d'un capteur électrique de champ magnétique (72).

4. Procédé selon l'une des revendications précédentes, **caractérisé en ce que** le champ magnétique (70) est conduit à travers un élément conduisant le champ magnétique (60).

5. Procédé selon la revendication 4, **caractérisé en ce que** l'élément conduisant le champ magnétique (60) est configuré de telle façon qu'il entoure au moins partiellement le conducteur (44) dans le sens azimutal.

6. Procédé selon la revendication 4 ou 5, **caractérisé en ce que** l'élément conduisant le champ magnétique (60) se termine des deux côtés du capteur de champ magnétique (72).

7. Procédé selon l'une des revendications 4 à 6, **caractérisé en ce que** l'élément conduisant le champ magnétique est formé d'un matériau magnétique doux.

8. Procédé selon l'une des revendications précédentes, **caractérisé en ce que** le champ magnétique (70) est mesuré à l'intérieur d'un support d'électrodes (32).

9. Unité électrochimique comprenant une unité de réaction, dans laquelle se déroule une réaction chimique superficielle, et un ensemble de contre-électrodes (20) appuyé d'un côté sur l'unité de réaction et configuré superficiellement ainsi qu'un ensemble d'électrodes (30) appuyé de l'autre côté sur l'unité de réaction et configuré superficiellement, lequel comprend un segment d'élément de contact (34s) configuré en conformité avec une zone locale de surface (40) de l'unité de réaction et assurant le contact avec celle-ci, un élément de contact (34) assurant le contact avec les autres zones de surface de l'unité de réaction et disposé électriquement en parallèle avec le segment de d'élément de contact (34s) et un capteur de champ magnétique (72), aussi bien l'élément de contact (34) que le segment d'élément de contact (34s) étant reliés avec une source de courant ou avec un élément abaisseur de courant (90) prévu pour l'exploitation de la réaction électrochimique et le segment d'élément de contact (34s) étant relié par l'intermédiaire d'un conducteur (44) avec la source de courant ou avec l'élément abaisseur de courant (90), en fonction de quoi un courant circulant à travers un conducteur (44) entre le segment d'élément de contact (34s) et la source de courant ou l'élément abaisseur de courant (90) génère autour du conducteur (44) un champ magnétique (70) qui peut être détecté au moyen du capteur de champ magnétique (72), **caractérisée en ce qu'**en plus de l'élément de contact (34) et du segment d'élément de contact (34s) l'ensemble d'électrodes (30) comprend un support d'électrodes (32), de telle sorte qu'au moyen du capteur de champ magnétique (72) le champ magnétique (70) généré par le courant circulant entre le support d'électrodes (32) et le segment d'élément de contact (34s) puisse être déterminé comme quantité pour la conversion de matière dans la zone locale de surface (40).

10. Unité électrochimique selon la revendication 9, **caractérisée en ce que** le conducteur (44) s'étend dans une direction (46) et **en ce que** le champ magnétique (70) tournant dans le sens azimutal autour de cette direction (46) peut être déterminé avec le capteur de champ magnétique (72).

11. Unité électrochimique selon la revendication 9 ou 10, **caractérisée en ce que** le champ magnétique (70) traverse un élément conduisant le champ magnétique (60).

12. Unité électrochimique selon la revendication 11, **caractérisée en ce que** l'élément conduisant le champ magnétique (60) entoure le conducteur (44) au moins partiellement dans le sens azimutal.

13. Unité électrochimique selon la revendication 11 ou 12, **caractérisée en ce que** l'élément conduisant le champ magnétique (60) est configuré de telle façon qu'il se termine des deux côtés du capteur de champ magnétique (72).

14. Unité électrochimique selon la revendication 13, **caractérisée en ce que** l'élément conduisant le champ magnétique (60) comprend une fente (68) dans laquelle est disposé le capteur de champ magnétique (72).

15. Unité électrochimique selon l'une des revendications 11 à 14, **caractérisée en ce que** l'élément conduisant le champ magnétique (60) est réalisé dans un matériau magnétique doux.

16. Unité électrochimique selon l'une des revendications 11 à 14, **caractérisée en ce que** l'élément conduisant le champ magnétique (60) est constitué de ferrite.

17. Unité électrochimique selon l'une des revendications 9 à 16, **caractérisée en ce qu'**un support d'électrodes (32) de l'ensemble d'électrodes (30) est configuré de telle façon que dans celui-ci est disposé le conducteur (44) conduisant au segment d'élément de contact (34).

18. Unité électrochimique selon la revendication 17, **caractérisée en ce que** le conducteur (44) est disposé sur une platine de support d'électrodes (42) ou sur le segment d'élément de contact et dépasse au-delà de celle-ci ou de celui-ci.

19. Unité électrochimique selon la revendication 17 ou 18, **caractérisée en ce que** dans le support d'électrodes (32) le conducteur (44) est entouré d'une cavité (56).

20. Unité électrochimique selon la revendication 19, **caractérisée en ce que** l'élément conduisant le champ magnétique (60) est disposé dans la cavité (56).

21. Unité électrochimique selon l'une des revendications 9 à 20, **caractérisée en ce que** le conducteur (44) est configuré en forme de tourillons.

22. Unité électrochimique selon la revendication 21, **caractérisée en ce que** le conducteur (44) configuré en forme de tourillons est formé d'une seule pièce sur la platine de support d'électrodes (42) ou sur l'élément de contact.

23. Unité électrochimique selon la revendication 21 ou 22, **caractérisée en ce que** le conducteur (44) configuré en forme de tourillons s'appuie sur un côté arrière (52) du segment d'élément de contact (34s).

24. Unité électrochimique selon l'une des revendications 19 à 23, **caractérisée en ce que** la cavité circulaire (56) est remplie d'un matériau n'exerçant pas d'influence sur le champ magnétique (70) et qui n'est pas électroconducteur.
